(19) Europäisches Patentamt
European Patent Office
Office européen des brevets

(11) **EP 4 191 901 A1**

(12) **EUROPEAN PATENT APPLICATION**
published in accordance with Art. 153(4) EPC

(43) Date of publication:
**07.06.2023 Bulletin 2023/23**

(21) Application number: **21857286.5**

(22) Date of filing: **04.06.2021**

(51) International Patent Classification (IPC):
**H04B 17/17** $^{(2015.01)}$

(52) Cooperative Patent Classification (CPC):
**H04B 17/17; H04B 17/29**

(86) International application number:
**PCT/CN2021/098453**

(87) International publication number:
**WO 2022/037187 (24.02.2022 Gazette 2022/08)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **18.08.2020 CN 202010833998**

(71) Applicant: **Huawei Technologies Co., Ltd.
Shenzhen, Guangdong 518129 (CN)**

(72) Inventors:
• HUO, Qiang
  **Shenzhen, Guangdong 518129 (CN)**
• YANG, Zhi
  **Shenzhen, Guangdong 518129 (CN)**
• ZOU, Zhiqiang
  **Shenzhen, Guangdong 518129 (CN)**

(74) Representative: **Maiwald GmbH
Engineering
Elisenhof
Elisenstrasse 3
80335 München (DE)**

(54) **METHOD AND APPARATUS FOR DETECTING PASSIVE INTER-MODULATION FAULT POINT**

(57) A passive inter-modulation fault point detection method and apparatus are provided, and relate to the field of wireless communication technologies. The method includes: sending, by a network device by using an antenna feeder system, a plurality of downlink signals of different frequencies, and receiving a first signal, where the first signal is an uplink PIM signal generated by excitation by any at least two downlink signals in the plurality of downlink signals; determining, by the network device, second signals corresponding to a plurality of detection points, where a second signal corresponding to any detection point is a pre-estimated signal for a PIM signal of the detection point; and determining, by the network device, a PIM fault point from the plurality of detection points based on the first signal and the second signals corresponding to the plurality of detection points. Therefore, without relying on a tester or an external device, the network device can detect the PIM fault point in the antenna feeder system.

A network device sends, by using an antenna feeder system, a plurality of downlink signals of different frequencies, and receives a first signal, where the first signal is an uplink PIM signal generated by excitation by any at least two downlink signals in the plurality of downlink signals — S410

The network device pre-estimates PIM signals of a plurality of detection points, to obtain a second PIM signal corresponding to each of the detection points — S420

The network device determines a PIM fault point from the plurality of detection points based on the first signal and the second signals corresponding to the plurality of detection points — S430

FIG. 4

**Description**

**CROSS-REFERENCE TO RELATED APPLICATIONS**

This application claims priority to Chinese Patent Application No. 202010833998.9, entitled "PASSIVE INTER-MODULATION FAULT POINT DETECTION METHOD AND APPARATUS" filed with the China National Intellectual Property Administration on August 18, 2020, which is incorporated by reference in its entirety.

**TECHNICAL FIELD**

This application relates to the field of wireless communication technologies, and in particular, to a passive inter-modulation fault point detection method and apparatus.

**BACKGROUND**

With the development of wireless communication systems, bandwidth and a quantity of antennas are growing increasingly, so that passive intermodulation (passive intermodulation, PIM) interference becomes an important factor that limits a system capacity.

Passive inter-modulation in a wireless communication system refers to an inter-modulation effect caused by non-linearity of passive devices, such as a connector, a feeder, an antenna, and a filter when the devices work under a condition of high-power signals of a plurality of frequencies. If downlink signals of two or more frequencies hit an inter-modulation fault point, a PIM signal of a new frequency is generated and reflected back to a receive end of the system. If the frequency of the PIM signal exactly falls within a receiving frequency range of a receive antenna, the receive antenna receives the PIM signal. The PIM signal causes interference to an uplink received signal, so that quality of the uplink received signal deteriorates, and then a system capacity is reduced or an available frequency band range of the system is narrowed.

The passive inter-modulation is mainly caused by material non-linearity and contact non-linearity. During device design and manufacturing, inter-modulation caused by the material non-linearity may be avoided by avoiding use of non-linear materials. However, the contact non-linearity is difficult to avoid, most inter-modulation is caused by the contact non-linearity, and connectors are an important inter-modulation source.

In an antenna feeder system, conventional PIM fault point detection needs to rely on a tester or an external device. However, due to a limitation of the tester or a working mechanism of the external device, an application scope is limited, and labor costs are high. For example, a solution in which a PIM fault point is detected by using a segmentation check method through manual on-site operations requires a tester to check PIM fault points one by one, which is time-consuming, inefficient, and has high costs, and cannot detect a plurality of PIM fault points simultaneously, either. In another example, a solution in which an external device is used to detect a PIM fault point by using a single frequency scanning method is generally applicable to only a narrow frequency range, and has poor universality, resulting in low accuracy of detecting the PIM fault point. When a scanning time is long, strength of a PIM signal varies with a temperature or the like in an actual environment, resulting in a large positioning error.

Because a passive inter-modulation problem is inevitable in an antenna feeder system, how to accurately, quickly, and cost-effectively find a PIM fault point without relying on an external device is an urgent problem to be resolved.

**SUMMARY**

Embodiments of this application provide a passive inter-modulation fault point detection method and apparatus, to help accurately, quickly, and cost-effectively find a passive inter-modulation PIM fault point in and/or near an antenna feeder system without relying on an external device.

According to a first aspect, an embodiment of this application provides a passive inter-modulation PIM fault point detection method. The method may be performed by a network device, for example, a base station or a baseband unit BBU in a base station, or may be performed by a component (for example, a chip or a circuit) configured in the network device. The method includes: The network device sends, by using an antenna feeder system, a plurality of downlink signals of different frequencies, and receives a first signal, where the first signal is an uplink PIM signal generated by excitation by any at least two downlink signals in the plurality of downlink signals; the network device determines second signals corresponding to a plurality of detection points, where a second signal corresponding to any detection point is a pre-estimated signal for a PIM signal of the detection point; and the network device determines a PIM fault point from the plurality of detection points based on the first signal and the second signals corresponding to the plurality of detection points.

By using the foregoing solution, without a tester and/or relying on an external device, the network device sends the plurality of signals of different frequencies in a downlink direction and receives the first signal in an uplink direction, and performs analysis and determining based on the first signal received in the uplink direction and pre-estimated PIM signals corresponding to the plurality of detection points, so that detection of a PIM fault point in and/or near the antenna feeder system can be implemented. The solution can be used to repair the network device before the network device is delivered from a factory, to effectively suppress (or eliminate) passive inter-modulation interference that may be generated by the network device. Alternatively, the solution can be used to repair the network device periodically or in a specific period in a process of using the network device, to effectively suppress the passive inter-modulation interference that may be generated by the network device. Therefore, the PIM fault point in the antenna feeder system is detected and suppressed, thereby avoiding generation of the passive inter-modulation interference, effectively improving performance of a communication system, and improving radio resource utilization.

In a possible design, that the network device determines a PIM fault point from the plurality of detection points based on the first signal and the second signals corresponding to the plurality of detection points includes: the network device determines PIM interference correlation coefficients corresponding to the plurality of detection points through the following step: obtaining a PIM interference correlation coefficient of at least one detection point based on the first signal and a second signal corresponding to the at least one detection point in the plurality of detection points; the network device determines, from the at least one detection point, at least one target detection point whose PIM interference correlation coefficient meets a first condition; and the network device determines that the target detection point is the PIM fault point.

By using the foregoing solution, a correlation coefficient that can represent PIM interference that may be generated at a detection point is obtained, and analysis and determining are performed based on the PIM interference correlation coefficient, to detect a PIM fault point in and/or near the antenna feeder system.

In a possible design, that the network device obtains a PIM interference correlation coefficient of at least one detection point based on the first signal and a second signal corresponding to the at least one detection point in the plurality of detection points includes: the network device determines a first sampling value of the first signal received at a preset reference point at each of a plurality of sampling moments; the network device determines, based on the second signal corresponding to the at least one detection point, a second sampling value of the second signal corresponding to the at least one detection point received at the preset reference point at each of the plurality of sampling moments; and the network device obtains the PIM interference correlation coefficient of the at least one detection point based on the first sampling value and the second sampling value corresponding to the at least one detection point.

By using the foregoing solution, a correlation analysis on an actually received uplink signal and pre-estimated PIM signals of the plurality of detection points may be converted into obtaining and analysis of PIM interference correlation coefficients corresponding to the detection points, thereby simplifying a related algorithm for detecting a PIM fault point by the network device, and also implementing detection of a plurality of PIM fault points in and/or near the antenna feeder system. During application, an algorithm related to the PIM interference correlation coefficient may be configured according to an application scenario or an application requirement.

As an example, a system of linear equations may be constructed based on a matrix corresponding to the first signal and a column vector corresponding to the second signal, and PIM interference correlation coefficients corresponding to the plurality of detection points are obtained by solving the system of linear equations. Specifically, the network device generates a first matrix based on an obtained second sampling value of a second signal of each detection point received at the preset reference point at each of the plurality of sampling moments, where the first matrix is an $N \times M$ matrix, N is a quantity of the plurality of sampling moments, M is a quantity of the plurality of detection points, and N and M are positive integers; the network device generates a second vector based on the obtained first sampling value of the first signal received at the preset reference point at each of the plurality of sampling moments, where the second vector is an $N \times 1$ column vector; and the network device constructs a system of linear equations based on the first matrix, the second vector, and a first vector, and obtains a PIM interference correlation coefficient by solving the system of linear equations, where the first vector is an $M \times 1$ column vector, and an element in the first vector is a PIM interference correlation coefficient corresponding to each detection point. Therefore, a relationship between the first signal actually received by using the antenna feeder system and the pre-estimated PIM signals corresponding to the plurality of detection points is converted into solving of a system of linear equations related to the PIM interference correlation coefficients of the detection points, so that detection of the plurality of PIM fault points and pre-estimation of corresponding interference power can be implemented quickly and accurately.

Alternatively, a transmission delay m may be used to represent a signal transmission delay corresponding to any detection point in and/or near the antenna feeder system, a correlation coefficient $\rho[m]$ corresponding to the transmission delay m may be obtained based on the first signal and the second signal, and all $\rho[m]$ are used to represent the PIM interference correlation coefficients corresponding to all the detection points. Specifically, for each detection point, the network device obtains the PIM interference correlation coefficient based on a ratio of a first value to a second value, where the first value is an inner product of a third vector and a fourth vector; the second value is an inner product of the fourth vector and the fourth vector; the third vector is an $N \times 1$ column vector, and an element in the third vector is the first signal received at the preset reference point at a sampling moment n, where n=1, 2, ..., N, and N is a positive integer; and the fourth vector is an N×1 column vector, and an element in the fourth vector is the second signal corresponding to the transmission delay m that is predicted to be received at the preset reference point at the sampling moment n, where the transmission delay m represents a transmission delay of an uplink PIM signal of the detection point. Therefore, a relationship between the first signal actually received by using the antenna feeder system and the plurality of pre-estimated PIM signals is converted into solving of the correlation coefficient of the transmission delay m corresponding to the detection point, so that detection of the plurality of PIM fault points and pre-estimation of corresponding interference power can be implemented quickly and accurately.

In a possible design, duration between any two adjacent sampling moments in the plurality of sampling moments is a sampling periodicity T; and the first condition includes: an absolute value of the PIM interference correlation coefficient is greater than or equal to a specified first threshold.

In a possible design, the first condition may be correspondingly set based on a specifically configured PIM fault point detection algorithm. For example, if the PIM interference correlation coefficient is obtained by solving a system of linear equations, the first condition may include: the absolute value of the PIM interference correlation coefficient is greater than or equal to the specified first threshold. Alternatively, if PIM fault point detection is performed by using the correlation coefficient ρ[m] corresponding to the transmission delay m and absolute values |ρ[m]| of all PIM interference correlation coefficients may form a function related to the detection points (represented by transmission delays m), the first condition may include: the absolute value of the PIM interference correlation coefficient is a maximum value, and the PIM interference correlation coefficient is greater than or equal to the specified first threshold. Therefore, the first condition that the PIM interference correlation coefficient should meet may be flexibly set based on a specifically used PIM fault point detection algorithm, to implement detection, analysis, and determining of a PIM fault point.

In a possible design, the preset reference point is a location of a transmitter power amplifier in the network device; or the preset reference point is a location of a combiner in the antenna feeder system.

By using the foregoing solution, a proper reference point may be selected according to a requirement for an algorithm. The location of the transmitter power amplifier or the location of the combiner is selected as the location of the preset reference point, so that the algorithm is simpler.

In a possible design, after the network device determines that the target detection point is the PIM fault point, the method further includes: the network device determines interference power of the PIM fault point based on the PIM interference correlation coefficient corresponding to the target detection point and the second signal.

By using the foregoing solution, after detection of the PIM fault point in the antenna feeder system is implemented, the interference power of the PIM fault point may be pre-estimated based on the PIM interference correlation coefficient of the PIM fault point and the pre-estimated second signal. Therefore, based on a known location of a PIM fault point and/or PIM interference power of a PIM fault point, interference suppression is performed on the PIM fault point, thereby avoiding generation of a passive inter-modulation interference signal, effectively improving performance of a communication system, and improving radio resource utilization.

In a possible design, that the network device determines second signals corresponding to a plurality of detection points includes: the network device determines the second signals of the plurality of detection points through the following step: determining a second signal corresponding to a first detection point in the plurality of detection points based on a configuration parameter of the first detection point and a preset signal pre-estimation model, where the configuration parameter of the first detection point includes at least one or a combination of the following: a location of the first detection point; carrier frequencies of the plurality of downlink signals; transmission rates and/or transmission delays of the plurality of downlink signals; a frequency of a PIM signal generated by excitation by any at least two downlink signals in the plurality of downlink signals; or a transmission rate and/or a transmission delay of the PIM signal generated by excitation by any at least two downlink signals in the plurality of downlink signals.

By using the foregoing solution, pre-estimation of a PIM signal may be implemented with reference to a plurality of configuration parameters. Because the plurality of parameters are relatively closely related to hardware and are slightly affected by an environment, a solution of implementing PIM fault point detection by pre-estimating the PIM signal with reference to these configuration parameters has a relatively small error, thereby helping implement relatively high detection precision.

In a possible design, the plurality of detection points meet any one of the following: the plurality of detection points are located in the antenna feeder system; the plurality of detection points are located near the antenna feeder system; or at least one of the plurality of detection points is located in the antenna feeder system, and at least one of the plurality of detection points is located near the antenna feeder system.

According to a second aspect, an embodiment of this application provides a passive inter-modulation PIM fault point detection apparatus. The apparatus may also have a function of implementing the network device in the first aspect or any one of the possible designs of the first aspect. The apparatus may be a network device, or may be a chip included in the network device. The function of the apparatus may be implemented by hardware, or may be implemented by hardware by executing corresponding software. The hardware or the software includes one or more modules or units or means (means) corresponding to the foregoing function.

In a possible design, a structure of the apparatus includes a processing unit and a transceiver unit, where the processing unit is configured to support the apparatus in performing corresponding functions of the network device in the first aspect or any one of the designs of the first aspect. The transceiver unit is configured to support communication between the apparatus and another communication device. For example, when the apparatus is a network device, a downlink signal may be sent by using an antenna feeder system, and an uplink signal may be received by using the antenna feeder system. The apparatus may further include a storage unit. A memory module is coupled to the processing unit, and stores necessary program instructions and necessary data of the apparatus. As an example, the processing unit may be a processor, the transceiver unit may be a transceiver, and the storage unit may be a memory. The memory may be integrated with the processor, or may be disposed separately from the processor. This is not limited in this application.

In a possible design, the transceiver unit is configured to send, by using an antenna feeder system, a plurality of downlink signals of different frequencies, and receive a first signal, where the first signal is an uplink PIM signal generated by excitation by any at least two downlink signals in the plurality of downlink signals; and the processing unit is configured to determine second signals corresponding to a plurality of detection points, and determine a PIM fault point from the plurality of detection points based on the first signal and the second signals corresponding to the plurality of detection points, where a second signal corresponding to any detection point is a pre-estimated signal for a PIM signal of the detection point.

In a possible design, the processing unit is specifically configured to: determine PIM interference correlation coefficients corresponding to the plurality of detection points through the following step: obtaining a PIM interference correlation coefficient of at least one detection point based on the first signal and a second signal corresponding to the at least one detection point in the plurality of detection points; determine, from the at least one detection point, at least one target detection point whose PIM interference correlation coefficient meets a first condition; and determine that the target detection point is the PIM fault point.

In a possible design, the processing unit is specifically configured to: determine a first sampling value of the first signal received at a preset reference point at each of a plurality of sampling moments; determine, based on the second signal corresponding to the at least one detection point, a second sampling value of the second signal corresponding to the at least one detection point received at the preset reference point at each of the plurality of sampling moments; and obtain the PIM interference correlation coefficient of the at least one detection point based on the first sampling value and the second sampling value corresponding to the at least one detection point.

In a possible design, duration between any two adjacent sampling moments in the plurality of sampling moments is a sampling periodicity T; and the first condition includes: an absolute value of the PIM interference correlation coefficient is greater than or equal to a specified first threshold.

In a possible design, the preset reference point is a location of a transmitter power amplifier in the network device; or the preset reference point is a location of a combiner in the antenna feeder system.

In a possible design, the processing unit is further configured to: determine, after determining that the target detection point is the PIM fault point, interference power of the PIM fault point based on the PIM interference correlation coefficient corresponding to the target detection point and the second signal.

In a possible design, the processing unit is specifically configured to: determine the second signals of the plurality of detection points through the following step: determining a second signal corresponding to a first detection point in the plurality of detection points based on a configuration parameter of the first detection point and a preset signal pre-estimation model, where the configuration parameter of the first detection point includes at least one or a combination of the following: a location of the first detection point; carrier frequencies of the plurality of downlink signals; transmission rates and/or transmission delays of the plurality of downlink signals; a frequency of a PIM signal generated by excitation by any at least two downlink signals in the plurality of downlink signals; or a transmission rate and/or a transmission delay of the PIM signal generated by excitation by any at least two downlink signals in the plurality of downlink signals.

In a possible design, the plurality of detection points meet any one of the following: the plurality of detection points are located in the antenna feeder system; the plurality of detection points are located near the antenna feeder system; or at least one of the plurality of detection points is located in the antenna feeder system, and at least one of the plurality of detection points is located near the antenna feeder system.

In another possible design, a structure of the PIM fault point detection apparatus includes a processor, and may further include a memory. The processor is coupled to the memory, and may be configured to execute computer program instructions stored in the memory, to enable the apparatus to perform the method in the first aspect or any one of the possible designs of the first aspect. Optionally, the apparatus further includes a communication interface, and the processor is coupled to the communication interface. When the apparatus is a network device, the communication interface may be a transceiver or an input/output interface. When the apparatus is a chip included in the network device, the communication interface may be an input/output interface of the chip. Optionally, the transceiver may be a transceiver circuit, and the input/output interface may be an input/output circuit.

According to a third aspect, an embodiment of this application provides a chip system, including: a processor. The processor is coupled to a memory, the memory is configured to store a program or instructions, and when the program or instructions are executed by the processor, the chip system is enabled to implement the method in the first aspect or any one of the possible designs of the first aspect.

Optionally, the chip system further includes an interface circuit, and the interface circuit is configured to exchange code instructions to the processor.

Optionally, there may be one or more processors in the chip system, and the processor may be implemented by hardware or may be implemented by software. When the processor is implemented by using the hardware, the processor may be a logic circuit, an integrated circuit, or the like. When the processor is implemented by using the software, the processor may be a general-purpose processor, and is implemented by reading software code stored in the memory.

Optionally, there may also be one or more memories in the chip system. The memory may be integrated with the processor, or may be disposed separately from the processor. This is not limited in this application. For example, the memory may be a non-transitory processor, for example, a read-only memory ROM. The memory and the processor may be integrated into a same chip, or may be separately disposed on different chips. A type of the memory and a manner of disposing the memory and the processor are not specifically limited in this application.

According to a fourth aspect, an embodiment of this application provides a computer-readable storage medium, storing a computer program or instructions. When the computer program or instructions are executed, a computer is enabled to perform the method in the first aspect or any one of the possible designs of the first aspect.

According to a fifth aspect, an embodiment of this application provides a computer program product. When a computer reads and executes the computer program product, the computer is enabled to perform the method in the first aspect or any one of the possible designs of the first aspect.

According to a sixth aspect, an embodiment of this application provides a communication system. The communication system includes the network device and at least one terminal device in the foregoing aspects.

In this application, on the basis of the implementations provided in the foregoing aspects, the implementations may be further combined to provide more implementations.

## BRIEF DESCRIPTION OF DRAWINGS

FIG. 1 is a schematic diagram of a network architecture of a communication system to which an embodiment of this application is applicable;
FIG. 2A and FIG. 2B are schematic diagrams of structures of a network device to which an embodiment of this application is applicable;
FIG. 3A and FIG. 3B are schematic diagrams of structures of an antenna feeder system to which an embodiment of this application is applicable;
FIG. 4 is a schematic flowchart of a PIM fault point detection method according to an embodiment of this application;
FIG. 5 is a schematic diagram of signal transmission in an antenna feeder system according to an embodiment of this application;
FIG. 6 is a schematic flowchart of a PIM fault point detection method according to an embodiment of this application;
FIG. 7 is a schematic flowchart of a PIM fault point detection method according to an embodiment of this application;
FIG. 8 is a schematic diagram of a structure of a PIM fault point detection apparatus according to an embodiment of this application; and
FIG. 9 is a schematic diagram of another structure of a PIM fault point detection apparatus according to an embodiment of this application.

## DESCRIPTION OF EMBODIMENTS

To resolve the problem mentioned in the background, this application provides a solution. In this solution, without relying on an external device, a network device sends a plurality of downlink signals of different frequencies in a downlink direction and receives a first signal in an uplink direction, and can detect a PIM fault point in an antenna feeder system based on the first signal received in the uplink direction and pre-estimation of PIM signals corresponding to a plurality of detection points. The plurality of detection points may be located in the antenna feeder system, or may be located near the antenna feeder system, or some detection points may be located in the antenna feeder system and other detection points may be located near the antenna feeder system. The solution can be used to repair the network device before the network device is delivered from a factory, to effectively suppress (or eliminate) a PIM signal that may be generated at a PIM fault point in and/or near the antenna feeder system of the network device. Alternatively, the solution can be used to repair the network device periodically or in a specific period in a process of using the network device, to effectively suppress the PIM signal that may be generated by the network device. Therefore, the PIM fault point is detected and suppressed, thereby avoiding generation of a passive inter-modulation interference signal, effectively improving performance of a communication system, and improving radio resource utilization.

To make objectives, technical solutions, and advantages of embodiments of this application clearer, the following further describes embodiments of this application in detail with reference to the accompanying drawings.

The technical solutions in embodiments of this application may be applied to various communication systems, for example, a long term evolution (long term evolution, LTE) system, an LTE frequency division duplex (frequency division duplex, FDD) system, an LTE time division duplex (time division duplex, TDD) system, a universal mobile telecommunications system (universal mobile telecommunications system, UMTS), a global system for mobile communication (global system for mobile communication, GSM), a 5th Generation (5th generation, 5G) mobile communication system or a new radio (new radio, NR) system, or a communication system applied to future.

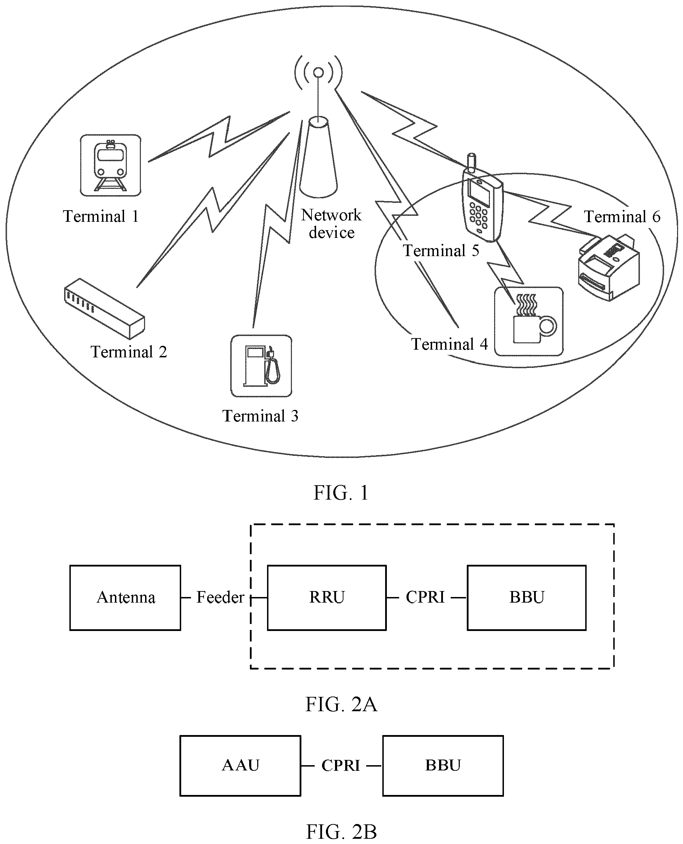

FIG. 1 is a schematic diagram of a structure of a communication system according to an embodiment of this application. The communication system includes a network device and at least one terminal device (for example, terminals 1 to 6 shown in FIG. 1). The network device may communicate with the at least one terminal device (for example, the terminal 1) through an uplink (uplink, UL) and a downlink (downlink, DL). The uplink refers to a physical layer communication link from the terminal device to the network device, and the downlink refers to a physical layer communication link from the network device to the terminal device.

Optionally, the network device has a plurality of transmit antennas and a plurality of receive antennas, and may communicate with the at least one terminal device by using a multiple-input multiple-output (multiple-input multiple-output, MIMO) technology.

In this embodiment of this application, a non-ideal factor used to generate a passive inter-modulation signal is referred to as a PIM source or a PIM fault point. Because passive inter-modulation interference is usually caused by non-linear characteristics of various passive devices (for example, a duplexer, an antenna, a feeder, and a radio frequency cable connector) in a transmit channel, the PIM source or the PIM fault point may also be referred to as a non-linear source.

It should be understood that, there may be a plurality of network devices in the communication system, and one network device may provide a service for a plurality of terminal devices. A quantity of network devices and a quantity of terminal devices included in the communication system are not limited in embodiments of this application. The network device in FIG. 1 and each of some or all of the at least one terminal device may implement the technical solutions provided in embodiments of this application. In addition, various terminal devices shown in FIG. 1 are merely some examples of the terminal device. It should be understood that, the terminal device in embodiments of this application is not limited thereto.

The solutions provided in this application are usually applied to a network device in a wireless communication system.

A network device mentioned in embodiments of this application, also referred to as an access network device, is a device that is in a network and that is configured to connect a terminal device to a wireless network. The network device may be a node in a radio access network, or may be referred to as a base station, or may be referred to as a RAN node (or device). The network device may be an evolved base station (evolved NodeB, eNodeB) in an LTE system or an evolved LTE system (LTE-Advanced, LTE-A), or may be a next generation base station (next generation NodeB, gNodeB) in a 5G NR system, or may be a NodeB (NodeB, NB), a base station controller (base station controller, BSC), a base transceiver station (base transceiver station, BTS), a transmission reception point (transmission reception point, TRP), a home base station (for example, a home evolved NodeB, or a home NodeB, HNB), a baseband unit (baseband unit, BBU), or a WiFi access point (access point, AP), a relay node, an integrated access and backhaul (integrated access and backhaul, IAB) node, a base station in a future mobile communication system, or the like, or may be a central unit (central unit, CU) and a distributed unit (distributed unit, DU). This is not limited in embodiments of this application. In a split deployment scenario in which the access network device includes the CU and the DU, the CU supports protocols such as a radio resource control (radio resource control, RRC) protocol, a packet data convergence protocol (packet data convergence protocol, PDCP), and a service data adaptation protocol (service data adaptation protocol, SDAP); and the DU mainly supports a radio link control (radio link control, RLC) layer protocol, a medium access control (medium access control, MAC) layer protocol, and a physical layer protocol.

For example, as shown in FIG. 2A, the network device may include one BBU, and a remote radio unit (remote radio unit, RRU) and an antenna (antenna) that are connected to the BBU. The BBU is mainly responsible for baseband algorithm-related calculation. The BBU exchanges with the RRU through a common public radio interface (common public radio interface, CPRI), and the RRU is connected to the antenna by using a feeder. It should be understood that, FIG. 2A is described by using an example in which one BBU is connected to one RRU. It should be understood that, in actual application, one BBU may be connected to one or more RRUs, and the network device may include more BBUs and RRUs connected to the BBUs. This is not limited in this application.

For example, as shown in FIG. 2B, the network device may include one BBU and an active antenna processing unit (active antenna processing unit, AAU) connected to the BBU. The BBU is mainly responsible for baseband algorithm-related calculation, and the BBU exchanges with the AAU through a common public radio interface (common public radio interface, CPRI). It should be understood that, FIG. 2B is described by using an example in which one BBU is connected to one AAU. It should be understood that, in actual application, one BBU may be connected to one or more AAUs, and the network device may include more BBUs and AAUs connected to the BBUs. This is not limited in this application.

A terminal device in embodiments of this application is a device having a wireless transceiver function, and may be deployed on land, including an indoor or outdoor device, a handheld device, a wearable device, or a vehicle-mounted device; or may be deployed on a water surface (for example, on a ship); or may be deployed in the air (for example, on a plane, a balloon, or a satellite). The terminal device may communicate with a core network through a radio access network (radio access network, RAN), and exchange voice and/or data with the RAN. The terminal device may be a mobile phone, a tablet computer, a computer having a wireless transceiver function, a mobile internet device, a wearable device, a virtual reality terminal device, an augmented reality terminal device, a wireless terminal in industrial control, a wireless terminal in self driving, a wireless terminal in telemedicine, a wireless terminal in a smart grid, a wireless terminal in transportation safety, a wireless terminal in a smart city, a wireless terminal in a smart home, or the like. Application scenarios are not limited in embodiments of this application. Sometimes, the terminal device may also be referred to as user equipment (user equipment, UE), a mobile station, a remote station, and the like. A specific technology, a device form, and a name that are used by the terminal device are not limited in embodiments of this application.

A carrier (which may also be referred to as a carrier frequency) in embodiments of this application refers to a radio wave having a particular frequency and bandwidth (for example, 10 M), and is used to carry a to-be-transmitted radio signal. A frequency band refers to some spectrum resources used in wireless communication, for example, an 1800 M frequency band used in the LTE system. Usually, one frequency band includes a plurality of carriers. For example, bandwidth of the 1800 M frequency band is 75 M, and then the frequency band may include m (m≥1) carriers whose bandwidth is 20 M and n (n≥1) carriers whose bandwidth is 10 M. Certainly, there may alternatively be another manner of defining a carrier. This is not limited in this application. In this application, one receive channel or transmit channel may process a signal that includes at least one carrier.

It should be noted that, in the following descriptions of embodiments of this application, uppercase boldface letters are used to represent a matrix, lowercase boldface letters are used to represent a vector, and $(\cdot)^H$, $(\cdot)^T$, and $(\cdot)^*$ are used to represent conjugate transpose, transpose, and complex conjugate transformation of a matrix/vector.

It should be noted that, the terms "system" and "network" may be used interchangeably in embodiments of this application. "A plurality of" means two or more. In view of this, "a plurality of" may also be understood as "at least two" in embodiments of this application. "At least one" may be understood as one or more, for example, one, two, or more. For example, including at least one means including one, two, or more, and does not limit which items are included. For example, if at least one of A, B, or C is included, A, B, C, A and B, A and C, B and C, or A, B, and C may be included. Similarly, understanding of descriptions such as "at least one type" is similar. The term "and/or" describes an association relationship for describing associated objects and represents that three relationships may exist. For example, A and/or B may represent the following three cases: Only A exists, both A and B exist, and only B exists. In addition, if there is no special description, the character "/" generally indicates an "or" relationship between the associated objects.

Unless otherwise stated, ordinal numbers such as "first" and "second" in embodiments of this application are used to distinguish between a plurality of objects, but are not intended to limit a sequence, a time sequence, priorities, or importance of the plurality of objects. In addition, descriptions of "first" and "second" do not necessarily indicate that objects are different.

To avoid problems of a limited application scope and high labor costs caused by use of a tester or an external device in a conventional PIM fault point detection solution, an embodiment of this application provides a PIM fault point detection method. The method is applicable to the network device in the communication system shown in FIG. 1, for example, the network device shown in FIG. 2A or FIG. 2B, and may detect a PIM fault point in an antenna feeder system of the network device.

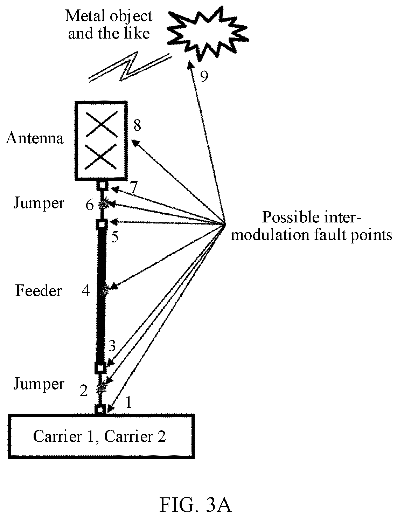

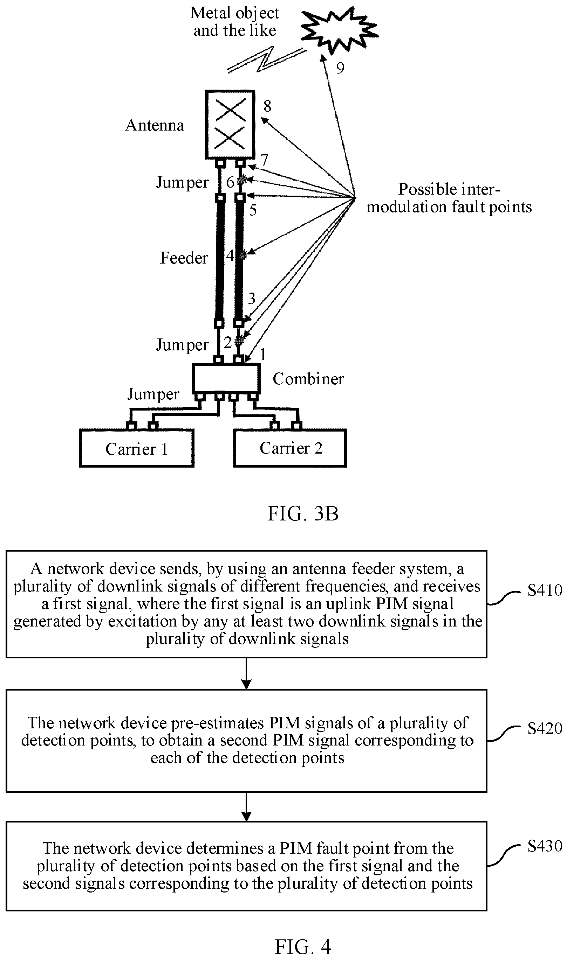

FIG. 3A and FIG. 3B are schematic diagrams of structures of an antenna feeder system to which an embodiment of this application is applicable. As shown in FIG. 3A or FIG. 3B, downlink signals that are sent by a network device by using a transmitter power amplifier and that are carried on carriers of different frequencies, for example, signals of a carrier 1 and a carrier 2, are sent after passing through a path of the antenna feeder system (for example, including a jumper, a combiner, a feeder, an antenna, and the like). If there is a PIM fault point on the path of the antenna feeder system, the signals of the carrier 1 and the carrier 2 are excited at the PIM fault point to generate an uplink PIM signal, and the uplink PIM signal causes interference to that the network device receives an uplink signal sent by a terminal device. By using the method in this embodiment of this application, detection of any PIM fault point on the path of the antenna feeder system can be implemented. In this embodiment of this application, a PIM fault point located near the antenna feeder system may also be considered as a PIM fault point in the antenna feeder system, and detection of the PIM fault point near the antenna feeder system is implemented by using the same method. Refer to FIG. 3A and/or FIG. 3B. For example, detection of inter-modulation fault points of connectors 1, 3, 5, and 7 in the antenna feeder system may be implemented, detection of inter-modulation fault points of metal objects attached to jumpers and feeders 2, 4, and 6 may also be implemented, and detection of an inter-modulation fault point 8 inside an antenna and detection of an inter-modulation fault point 9 of a metal object in an environment near the antenna may also be implemented. The following describes specific steps of the method in detail with reference to a flowchart of a method shown in FIG. 4.

S410: A network device sends, by using an antenna feeder system, a plurality of downlink signals of different frequencies, and receives a first signal.

The plurality of downlink signals sent by the network device in a downlink direction by using the antenna feeder system may be broadband signals when the network device and the antenna feeder system normally work. The plurality of downlink signals are sent by using a plurality of carriers, and frequencies of these carrier frequencies may be different. If there is a PIM fault point in or near the antenna feeder system, when the downlink signals carried on the plurality of carriers of different frequencies arrive at the PIM fault point, an uplink PIM signal is excited at the PIM fault point. The first signal received by the network device by using the antenna feeder system is an uplink PIM signal generated by excitation by any at least two downlink signals of different frequencies in the plurality of downlink signals.

S420: The network device pre-estimates PIM signals of a plurality of detection points, to obtain a pre-estimated signal of a PIM signal corresponding to each of the detection points. For ease of differentiation and description, the pre-estimated signal of the PIM signal corresponding to each of the detection points may also be referred to as a second signal.

In this embodiment of this application, the plurality of detection points may be located in the antenna feeder system, or the plurality of detection points may also be located near the antenna feeder system (for example, the inter-modulation fault point 9 of the metal object shown in FIG. 3A or FIG. 3B), or some detection points in the plurality of detection points are located in the antenna feeder system and some detection points are located near the antenna feeder system. The PIM fault point may be one or more of the plurality of detection points. This is not limited in this application.

In a possible design, the network device determines the second signals corresponding to the plurality of detection points through the following step: determining a second signal corresponding to a first detection point in the plurality of detection points based on a configuration parameter of the first detection point and a preset signal pre-estimation model. The signal pre-estimation model may be a pre-obtained signal pre-estimation model, for example, a Volterra model. For example, the configuration parameter of the first detection point may include at least one or a combination of the following: a location of the first detection point; carrier frequencies of the plurality of downlink signals; transmission rates and/or transmission delays of the plurality of downlink signals; a frequency of a PIM signal generated by excitation by any at least two downlink signals in the plurality of downlink signals; or a transmission rate and/or a transmission delay of the PIM signal generated by excitation by any at least two downlink signals in the plurality of downlink signals.

It should be understood that, herein, the first detection point is only used to represent any detection point in the plurality of detection points, rather than any limitation on the detection point. In addition, in actual application, a location of a detection point may be represented by, for example, a distance between the detection point and a preset reference point; or the preset reference point may be used as an origin, and spatial coordinate information is used to represent the location of the detection point. The carrier frequencies of the plurality of downlink signals may be frequencies of carriers (which may also be referred to as center frequencies), or may be frequencies of subcarriers. The PIM signal corresponding to the plurality of downlink signals may include any PIM signal that may be generated by excitation by any at least two downlink signals in the plurality of downlink signals, including but not limited to third-order passive inter-modulation PIM3, fifth-order passive inter-modulation PIM5, seventh-order passive inter-modulation PIM7, and the like. The frequency of the PIM signal is determined based on frequencies of the at least two downlink signals that are excited to generate the PIM signal. This is not limited in this application.

Embodiments of this application may be applied to a two-carrier (that is, downlink signals are sent by using two downlink carriers of different frequencies) scenario, or may be applied to a multi-carrier (that is, downlink signals are sent by using three or more downlink carriers of different frequencies) scenario, and may be applied to a case of third-order inter-modulation, or may be applied to a case of another order (for example, fifth-order inter-modulation or seventh-order inter-modulation). This is not limited in this application.

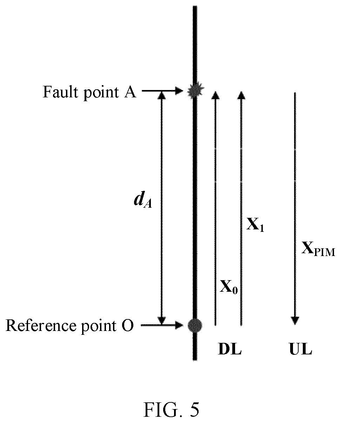

For ease of understanding, with reference to FIG. 5, the following describes a manner of obtaining the second signals corresponding to the plurality of detection points by using a two-carrier scenario and third-order inter-modulation PIM3 as an example. It should be understood that, this is merely an example for description rather than any limitation herein. In another multi-carrier scenario or another PIM order inter-modulation scenario, parameter replacement may be correspondingly performed based on information such as the carrier frequencies of the plurality of downlink signals and/or frequencies of other PIM orders, to obtain, in a corresponding scenario, the pre-estimated PIM signals corresponding to the plurality of detection points.

Refer to FIG. 5. Two downlink carriers of different frequencies are respectively denoted as $DL_0$ and $DL_1$. A frequency of $DL_0$ is denoted as $f_0$, and a frequency of $DL_1$ is denoted as $f_1$. A frequency of a third-order inter-modulation signal PIM3 generated by $DL_0$ and $DL_1$ is denoted as $f_p = 2f_0 - f_1$, and a frequency of an uplink carrier is denoted as $f_{UL}$.

A network device may select a preset reference point O, use a location of the preset reference point as a reference, and denote a distance $d_A$ between any detection point A in a plurality of detection points and the preset reference point as a location of the detection point A. The preset reference point may be any location point in a link, may be a location of a transmitter power amplifier in the network device, or may be a predetermined location that is relatively close to the transmitter power amplifier in the network device, for example, a location of a combiner in an antenna feeder system (as shown in FIG. 3B). This may be specifically set according to an application scenario or an application requirement. This is not limited in this application.

Assuming that the selected preset reference point O is the location of the combiner in the antenna feeder system and signal sampling is performed based on time, downlink signals corresponding to the two downlink carriers at the preset reference point O at a sampling moment n are respectively denoted as $X_0[n]$ and $X_1[n]$, and modulated downlink signals are respectively:

$$X_0[n]e^{j2\pi f_0 nT} \text{ and } X_1[n]e^{j2\pi f_1 nT}$$

Duration between any two adjacent sampling moments in a plurality of sampling moments is a sampling period T.

Assuming that a third-order PIM interference signal PIM3 is generated at the preset reference point O and a frequency of the PIM3 is $f_p = 2f_0 - f_1$, based on a pre-obtained signal pre-estimation model, a PIM signal (not demodulated) that is pre-estimated and that may be generated at the preset reference point O may be represented by the following expression:

$$Q_0[n] = X_0[n]X_0[n]X_1^*[n]e^{j2\pi(2f_0-f_1)nT} \tag{1}$$

After $Q_0[n]$ is demodulated based on the frequency $f_{UL}$ of the uplink carrier, a corresponding PIM signal may be represented by the following expression:

$$P_0[n] = X_0[n]X_0[n]X_1^*[n]e^{j2\pi(2f_0-f_1-f_{UL})nT} \tag{2}$$

If inter-modulation occurs at the detection point A, a process in which downlink signals are sent at the preset reference point O and a PIM signal from the detection point A is received is shown in FIG. 5. Assuming that the distance between the detection point A and the preset reference point O is $d_A$, considering a signal transmission delay, a PIM signal (not demodulated) generated by excitation at the detection point A at the sampling moment n may be represented by the following expression:

$$R_A[n] = X_0[n-m_0]X_0[n-m_0]X_1^*[n-m_1]e^{j2\pi 2f_0(n-m_0)T}e^{-j2\pi f_1(n-m_1)T} \tag{3}$$

$m_0$ and $m_1$ respectively represent transmission delays corresponding to the downlink signals whose carrier frequencies are $f_0$ and $f_1$ when a propagation distance in a transmission medium (for example, a path of the antenna feeder system) is $d_A$.

Correspondingly, the PIM signal (not demodulated) from the detection point A that may be received at the preset reference point O at the sampling moment n may be represented by the following expression:

$$Q_A[n] = X_0[n-m_0-m_P]X_0[n-m_0-m_P]X_1^*[n-m_1-m_P]e^{j2\pi(2f_0-f_1)(n-m_P)T}e^{-j2\pi(2f_0m_0T-f_1m_1T)} \tag{4}$$

$m_0$, $m_1$, and $m_p$ respectively represent transmission delays corresponding to the downlink signals whose carrier frequencies are $f_0$ and $f_1$ and an uplink PIM signal whose frequency is $f_P$ when the propagation distance in the transmission medium (for example, a path of the antenna feeder system) is $d_A$.

After $Q_A[n]$ is demodulated based on the frequency $f_{UL}$ of the uplink carrier, the PIM signal from the detection point A that may be received at the preset reference point O at the sampling moment n may be represented by the following expression:

$$P_A[n] = X_0[n - m_0 - m_P]X_0[n - m_0 - m_P]X_1^*[n - m_1$$

$$- m_P]e^{j2\pi(2f_0 - f_1)(n - m_P)T}e^{-j2\pi(2f_0 m_0 T - f_1 m_1 T)}e^{-j2\pi f_{UL}nT} \tag{5}$$

$P_A[n]$ obtained by using the foregoing expression (5) represents a second signal corresponding to any detection point A that is obtained by pre-estimation.

For a plurality of other detection points in the antenna feeder system or other detection points near the antenna feeder system, a second signal corresponding to each of the detection points may be obtained in the same manner as described above, and details are not described herein again.

In addition, in specific implementation, the second signal $P_A[n]$ corresponding to the detection point A may also have a plurality of implementation forms. This is not limited in this application.

For example, in a communication system shown in FIG. 3A, if a location of the transmitter power amplifier in the network device is selected as the location of the preset reference point, because there are also some transmission lines between a baseband chip and the transmitter power amplifier, a transmit signal and/or a receive signal that are/is used for calculation in the baseband chip further need to be offset, to compensate for a transmission delay of this part of the transmission path. The part of the path is fixed in hardware implementation. Therefore, in practice, the offset of the compensation may also be obtained in advance. In a communication system shown in FIG. 3B, if the antenna feeder system includes the combiner and a location of the combiner is selected as the location of the preset reference point, because a distance between the combiner in the antenna feeder system and the transmitter power amplifier in the network device is shorter compared with an entire path (including the feeder connecting the power amplifier and the antenna) of the antenna feeder system, a transmission delay corresponding to this part of the transmission path may be ignored, that is, that the preset reference point is disposed at the location of the combiner is considered as that the preset reference point is disposed at a location of a baseband chip.

For example, if propagation speeds of the signals whose frequencies are $f_0$, $f_1$, and $f_P$ in the transmission medium are respectively $v_0$, $v_1$, and $v_P$, corresponding transmission delays may be represented as $m_0 = \frac{d_A}{v_0 T}$, $m_1 = \frac{d_A}{v_1 T}$, and $m_P = \frac{d_A}{v_P T}$. In $P_A[n]$ obtained by using the foregoing expression (5), a corresponding transmission delay in the foregoing $P_A[n]$ may be replaced based on the distance $d_A$ between the detection point A and the preset reference point O, transmission rates $v_0$ and $v_1$ corresponding to the downlink signals in the antenna feeder system, and a transmission rate $v_P$ corresponding to the PIM signal in the antenna feeder system.

For example, assuming that $v = v_0 \approx v_1 \approx v_P$ and $m = \frac{d_A}{vT}$, the $P_A[n]$ expression obtained by using the foregoing expression (5) may also be shown as follows:

$$P_A[n] \approx X_0[n - 2m]X_0[n - 2m]X_1^*[n - 2m]e^{j2\pi(2f_0 - f_1 - f_{UL})nT}e^{-j2\pi(2f_0 - f_1)2mT} \tag{6}$$

m represents a transmission delay corresponding to the distance $d_A$ between any detection point A and the preset reference point O.

For example, if the preset reference point O is selected at another location in the path of the antenna feeder system, a signal offset further needs to be performed. Specifically, assuming that a distance between the preset reference point O and the transmitter power amplifier is denoted as $d_O$ and a signal transmission delay between the preset reference point O and the transmitter power amplifier is denoted as $m_O$, after a signal offset is performed, the $P_A[n]$ expression obtained by using the foregoing expression (5) may be shown as follows:

$$P_A[n]' \approx P_A[n + 2m_O]e^{j2\pi f_{UL}2m_O T} \tag{7}$$

$P_A[n]'$ represents the second signal corresponding to the detection point A after the signal offset is performed, that is, a pre-estimated signal of the PIM signal from the detection point A that may be received at the preset reference point O at the sampling moment n.

It should be noted that, the foregoing embodiment is merely an example for describing a manner of obtaining a second signal corresponding to a detection point rather than any limitation. In other embodiments, the second signal corresponding to the detection point may be determined in another manner. For example, a received first signal may be sampled within a predetermined time period, and correspondingly, a second signal corresponding to each of detection points within a corresponding time period may be determined based on the predetermined time period and a signal transmission delay between the detection point and the preset reference point. This is not limited in this application.

S430: The network device determines a PIM fault point from the plurality of detection points based on the first signal and the second signals corresponding to the plurality of detection points.

In this embodiment of this application, the network device can perform analysis and determining based on the first signal actually received by using the antenna feeder system and the pre-estimated PIM signals corresponding to the plurality of detection points, so that detection of a PIM fault point in and/or near the antenna feeder system can be implemented efficiently and cost-effectively without relying on a tester and an external device. This solution can simultaneously implement high-precision detection of a plurality of PIM fault points, and obtain related interference parameters of the PIM fault points.

In a possible design, S430 may specifically include: the network device determines PIM interference correlation coefficients corresponding to the plurality of detection points through the following step: obtaining a PIM interference correlation coefficient of at least one detection point based on the first signal and a second signal corresponding to the at least one detection point in the plurality of detection points; the network device determines, from the at least one detection point, at least one target detection point whose PIM interference correlation coefficient meets a first condition; and the network device determines that the target detection point is the PIM fault point.

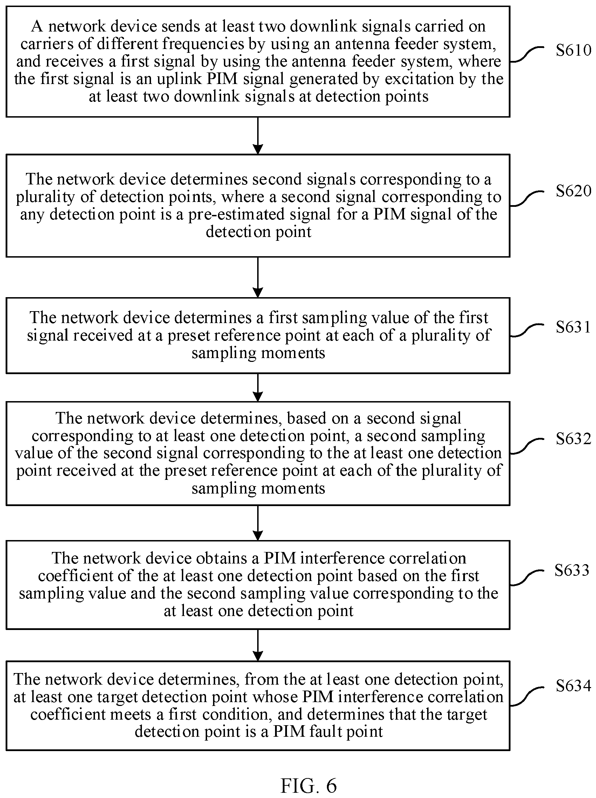

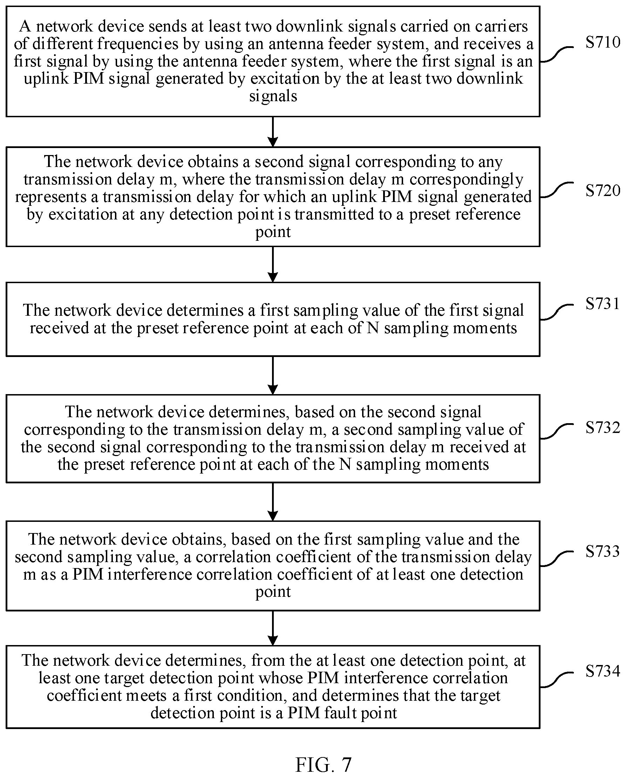

In actual application, a PIM fault point detection algorithm may be configured according to an application scenario or an application requirement, to perform analysis and determining based on a PIM interference correlation coefficient of any detection point in and/or near the antenna feeder system, thereby implementing detection of a PIM fault point. For ease of understanding, the following provides detailed descriptions with reference to flowcharts of methods shown in FIG. 6 and FIG. 7.

As shown in FIG. 6, a PIM fault point detection method includes the following steps:

S610: A network device sends at least two downlink signals carried on carriers of different frequencies by using an antenna feeder system, and receives a first signal by using the antenna feeder system, where the first signal is an uplink PIM signal generated by excitation by the at least two downlink signals at a PIM fault point.

S620: The network device determines second signals corresponding to a plurality of detection points.

All locations (for example, as shown in FIG. 3A and FIG. 3B) in and/or near the antenna feeder system that may be locations of PIM fault points are selected as detection points, $P_i[n]$ is used to represent a pre-estimated signal of a PIM signal that is generated at a detection point i and received at a preset reference point O, $i = 1, 2, ..., M$, M is a quantity of the detection points, and a distance between the detection point i and the preset reference point O is denoted as $d_i$. For a process in which the network device obtains the second signals corresponding to the plurality of detection points, reference may be made to the foregoing related descriptions with reference to FIG. 5. Details are not described herein again.

S631: The network device determines a first sampling value of the first signal received at a preset reference point at each of a plurality of sampling moments.

S632: The network device determines, based on a second signal corresponding to at least one detection point in the plurality of detection points, a second sampling value of the second signal corresponding to the at least one detection point received at the preset reference point at each of the plurality of sampling moments.

Assuming that the preset reference point O is selected as a location of a combiner, an uplink signal received at the preset reference point O at a sampling moment n is denoted as $Y[n]$, and is considered as the first signal received in S610. It should be understood that, herein, only an example in which the location of the combiner in the antenna feeder system is used as a location of the preset reference point is used for description, rather than any limitation on this embodiment of this application. In actual application, if another location in a path of the antenna feeder system is selected as the location of the preset reference point O, a signal obtained after a signal offset is performed on a received uplink signal is correspondingly considered as the first signal received in S610. Specifically, a distance between the preset reference point O and a transmitter power amplifier may be denoted as $d_O$, the uplink signal received at the preset reference point O is denoted as $y[n]$, and a first signal $Y[n] \approx y[n + 2m_O]e^{j2\pi f_{UL}2m_O T}$ is obtained after a signal offset is performed, where $m_O$ is a transmission delay corresponding to the uplink signal generated at the preset reference point O when a propagation distance in a transmission medium is $d_O$. In this embodiment, for ease of description, the location of the combiner is selected as the location of the preset reference point O, and $Y[n]$ is used to represent the first signal received in S610.

Assuming that the first signal received by the network device by using the antenna feeder system is synthesized by PIM signals generated at all detection points, the first signal is represented as $Y[n] = \sum_i w_i P_i[n]$, where $w_i$ is a PIM

interference correlation coefficient corresponding to the detection point i, an amplitude of the PIM interference correlation coefficient corresponding to the detection point i is related to strength of a PIM signal at the detection point, and if $w_i = 0$, it represents that there is no inter-modulation fault point at the detection point; and $P_i[n]$ is a pre-estimated signal of the PIM signal that is generated by excitation at the detection point i and received at the preset reference point O. For a manner of obtaining $P_i[n]$, reference may be made to the foregoing related descriptions. Details are not described herein again.

S633: The network device obtains a PIM interference correlation coefficient of the at least one detection point based on the first sampling value and the second sampling value corresponding to the at least one detection point.

In a possible design, Y[n] may be used to represent the first sampling value of the first signal received in S610, $P_i[n]$ may be used to represent a second sampling value of a second signal corresponding to the detection point i, a system of linear equations shown in the following expression (8) may be constructed based on the first sampling value and the second sampling value corresponding to the at least one detection point, and the PIM interference correlation coefficient corresponding to the at least one detection point is obtained by solving the system of linear equations.

$$P\vec{w} = \vec{Y} \qquad\qquad (8)$$

P is an N×M matrix, an element of an $n^{th}$ row and an $i^{th}$ column in P is $P_i[n]$, and represents the second signal corresponding to the detection point i that is predicted to be received at the preset reference point O at the sampling moment n, i=1, 2, ..., M, n=1, 2, ..., N, N is a quantity of sampling points, M is a quantity of detection points, and N and M are positive integers; $\vec{Y}$ is a N × 1 column vector, and an element in $\vec{Y}$ is the first signal received at the preset reference point O at the sampling moment n; and $\vec{w}$ is a M × 1 column vector, an element in $\vec{w}$ is the PIM interference correlation coefficient corresponding to the detection point i, i=1, 2, ..., M, and M is a positive integer.

Therefore, the PIM interference correlation coefficient $w_i$ corresponding to the detection point i is used as an unknown number, obtaining of the PIM interference correlation coefficient corresponding to the detection point i is converted into solving of the system of linear equations of M elements, and a PIM interference correlation coefficient corresponding to each of the detection points may be obtained by solving the system of linear equations (8). If the quantity N of sampling points is enough, it may represent that a rank of the P matrix meets rank(P) = M, that is, the system of equations has a unique solution or has no solution. In this case, the foregoing system of linear equations may be solved or approximately solved, so that $\|P\vec{w} - \vec{Y}\|_2$ is minimized. Correspondingly, $\vec{w}$ is a solution or an approximate solution, and $\|\ \|_2$ herein represents 2-norm.

S634: The network device determines, from the at least one detection point, at least one target detection point whose PIM interference correlation coefficient meets a first condition, and determines that the target detection point is the PIM fault point.

In a possible design, the first condition may include: an absolute value of the PIM interference correlation coefficient is greater than or equal to a specified first threshold. After the PIM interference correlation coefficient $w_i$ corresponding to the detection point i is obtained, absolute values $|w_i|$ of PIM interference correlation coefficients of all detection points i are compared with a specified first threshold $\gamma_w$ to determine whether the first condition is met. If $|w_i|$ is greater than or equal to the first threshold $\gamma_w$, it is determined that the detection point i corresponding to $w_i$ is a target detection point, and it is determined that the target detection point is a PIM fault point. A location of a detection point is, for example, a distance $d_i$ between the detection point i and the preset reference point O. A location of the detection point i may be determined based on the location of the preset reference point O and the distance $d_i$.

In a possible design, after determining that the target detection point i is the PIM fault point, the network device may further determine interference power of the PIM fault point based on the PIM interference correlation coefficient of the target detection point and the second signal. For example, when the detection point i is the PIM fault point, interference power of the PIM signal generated at the detection point i is an average value of modulus squares $|w_i P_i[n]|^2$ of a product of the PIM interference correlation coefficient $w_i$ of the detection point i and the second signal $P_i[n]$ corresponding to the detection point i at the sampling moment n, that is, $\frac{1}{N}\sum_{n=1}^{N}|w_i P_i[n]|^2$. n=1, 2, ..., N, N is the quantity of sampling points, and N is a positive integer.

Therefore, through the foregoing embodiment, without relying on a tester and an external device, the network device sends the plurality of downlink signals of different frequencies in a downlink direction and receives the PIM signal in an uplink direction, and can detect a PIM fault point in and/or near the antenna feeder system and pre-estimation of interference power based on the PIM signal received in the uplink direction and pre-estimation of the PIM signals corresponding to the plurality of detection points.

Further, after the detection of the PIM fault point is implemented, correspondingly, interference suppression may be further performed on the PIM fault point, thereby avoiding generation of a passive inter-modulation interference signal, effectively improving performance of a communication system, and improving radio resource utilization. Specifically, for example, after determining that the detection point i is the PIM fault point, the network device may eliminate, in the received uplink signal, a component that is the same as the second signal corresponding to the detection point i, thereby reducing impact of PIM interference on the communication system.

In addition, in this embodiment of this application, to improve system detection precision, a data sampling rate may also be increased, for example, a sampling interval T between two sampling moments is reduced; or a signal may also be continuously sampled within a predetermined time period. In other words, a larger quantity of sampling points indicates higher detection precision.

Therefore, by using the method shown in FIG. 6, a relationship between the first signal actually received by using the antenna feeder system and the pre-estimated PIM signals of the plurality of detection points may be converted into solving of a system of linear equations, so that detection of a plurality of PIM fault points and pre-estimation of corresponding interference power are implemented quickly and accurately. The solution can be used to repair the network device before the network device is delivered from a factory, to effectively suppress (or eliminate) a passive inter-modulation interference signal that may be generated by the network device. Alternatively, the solution can be used to repair the network device periodically or in a specific period in a process of using the network device, to effectively suppress the passive inter-modulation interference signal that may be generated by the network device. Therefore, the PIM fault point is detected and suppressed, thereby avoiding generation of the passive inter-modulation interference signal, effectively improving performance of a communication system, and improving radio resource utilization.

As shown in FIG. 7, a method includes the following steps:

S710: A network device sends at least two downlink signals carried on carriers of different frequencies by using an antenna feeder system, and receives a first signal by using the antenna feeder system, where the first signal is an uplink PIM signal generated by excitation by the at least two downlink signals.

S720: The network device obtains a second signal corresponding to any transmission delay m.

The transmission delay m correspondingly represents a transmission delay for which an uplink PIM signal generated by excitation at any detection point in and/or near an antenna feeder system is transmitted to a preset reference point. In this embodiment, the transmission delay m is used to correspondingly represent any detection point, and the second signal corresponding to the transmission delay m is a pre-estimated PIM signal corresponding to the detection point.

According to the foregoing related descriptions with reference to FIG. 5, assuming that a preset reference point O is selected as a location of a combiner in the antenna feeder system, and assuming that $v = v_0 \approx v_1 \approx v_P$ and $m = \frac{d_A}{vT}$, by using a signal pre-estimation model, a PIM signal of any detection point A that may be received at the preset reference point O at a sampling moment n may be represented by the following expression (9):

$$P_A[n] \approx X_0[n-2m]X_0[n-2m]X_1^*[n-2m]e^{j2\pi(2f_0-f_1-f_{UL})nT}e^{-j2\pi(2f_0-f_1)2mT}$$

$$\approx P_0[n-2m]e^{-j2\pi f_{UL}2mT} \tag{9}$$

In this embodiment of this application, because a fixed overall phase is added to a known sequence and impact on a location of a PIM fault point and a pre-estimation result of interference power is relatively small, $P_0[n - 2m]$ may also be used to approximately represent $P_A[n]$ corresponding to the detection point A in the foregoing expression (9), and detection of the PIM fault point in and/or near the antenna feeder system is performed based on $P_0[n - 2m]$.

For a process in which the network device obtains second signals corresponding to a plurality of detection points, reference may be made to the foregoing related descriptions with reference to FIG. 5. Details are not described herein again.

S731: The network device determines a first sampling value of the first signal received at the preset reference point at each of N sampling moments. Assuming that the preset reference point O is selected as the location of the combiner in the antenna feeder system, an uplink signal received at the preset reference point O at the sampling moment n is denoted as Y[n], and is considered as the first sampling value of the first signal received in S710. For details, reference may be made to the foregoing related descriptions. Details are not described herein again.

S732: The network device determines, based on the second signal corresponding to the transmission delay m, a second sampling value of the second signal corresponding to the transmission delay m received at the preset reference point at each of the N sampling moments.

In this embodiment, the second signal $P_0[n - 2m]$ corresponding to the transmission delay m is used to approximately represent a second sampling value of a second signal $P_A[n]$ corresponding to the detection point A received at the sampling moment n. The transmission delay m represents a transmission delay for which an uplink PIM signal generated by excitation at the detection point A is transmitted to the preset reference point.

S733: The network device obtains, based on the first sampling value and the second sampling value corresponding to the transmission delay m, a correlation coefficient $\rho[m]$ of the transmission delay m as a PIM interference correlation coefficient of a first detection point.

The correlation coefficient $\rho[m]$ of the transmission delay m is defined as the following expression (10):

$$\rho[m] = \frac{\sum_{n=1}^{N} Y[n] P_0^*[n - 2m]}{\sum_{n=1}^{N} |P_0[n - 2m]|^2} \tag{10}$$

* is a complex conjugate; $\sum_{n=1}^{N} Y[n] P_0^*[n - 2m]$ is a first value, and represents an inner product of a first sampling value $Y[n]$ of the first signal received at the preset reference point O and the second sampling value $P_0[n - 2m]$ of the second signal corresponding to the transmission delay m at each of the N sampling moments; and $\sum_{n=1}^{N} |P_0[n - 2m]|^2$ is a second value, and represents an inner product of the second sampling value $P_0[n - 2m]$ of the second signal corresponding to the transmission delay m and the second sampling value $P_0[n - 2m]$ at each of the N sampling moments.

For any detection point A in the antenna feeder system, the correlation coefficient $\rho[m]$ corresponding to the transmission delay m may be used to represent a PIM interference correlation coefficient corresponding to the detection point A. Therefore, PIM interference correlation coefficients corresponding to detection points are obtained in the foregoing manner, and details are not described herein again.

S734: The network device determines, from the at least one detection point, at least one target detection point whose PIM interference correlation coefficient meets a first condition, and determines that the target detection point is a PIM fault point.

In a possible design, the first condition may include: an absolute value of the PIM interference correlation coefficient is a maximum value, and the absolute value of the PIM interference correlation coefficient is greater than or equal to a first threshold. By using the foregoing expression (10), the transmission delay m is used as an independent variable, and $\rho[m]$ is used as a dependent variable, so that coefficients $\rho[m]$ corresponding to all transmission delays m can be obtained. All peak values (also referred to as maximum values) are selected from all $\rho[m]$, and are recorded as $|\rho[m_{peak}]|$. $|\rho[m_{peak}]|$ is compared with a first threshold $\gamma_\rho$ to determine whether the first condition is met. If $|\rho[m_{peak}]|$ is greater than or equal to the first threshold $\gamma_\rho$, it is determined that a location corresponding to the maximum value $|\rho[m_{peak}]|$ is determined as a target detection point, it is determined that the target detection point is a PIM fault point, and a distance between a location of the PIM fault point and the preset reference point O is $d_m = mvT$, where m is a transmission delay, v is a transmission rate of a signal in the antenna feeder system, and T is a sampling time interval.

In a possible design, after determining that a target detection point i is a PIM fault point, the network device may further determine interference power of the PIM fault point based on a PIM interference correlation coefficient of the target detection point and the second signal. Specifically, for example, interference power of a PIM signal generated at a PIM fault point corresponding to a transmission delay m is:

$$|\rho[m_{peak}]|^2 \times \frac{1}{N} \sum_{n=1}^{N} |P_0[n - 2m_{peak}]|^2$$

n=1, 2,..., N, where N is a quantity of sampling points, and N is a positive integer; and $m_{peak}$ represents a transmission delay corresponding to a location that is determined as a location of the PIM fault point, v represents a transmission rate of a signal in the antenna feeder system, T is a sampling time interval, $\rho[m_{peak}]$ is a PIM interference correlation coefficient corresponding to the PIM fault point, and $P_0[n - 2m_{peak}]$ is a second signal corresponding to the PIM fault point at a sampling moment n.

In addition, in a case in which bandwidth is large enough and the quantity of sampling points is enough, proper downlink broadband signals $X_0[n]$ and $X_1[n]$ may be selected, so that for any $m_1 \neq m_2$:

$$\lim_{N \to \infty} \sum_{n=1}^{N} P_0[n - 2m_1] P_0^*[n - 2m_2] = 0$$

therefore, the foregoing coefficients $\rho[m]$ are equivalent to $w_i$ in the embodiment shown in FIG. 6, where N is the quantity of sampling points, $m_1$ is a transmission delay from a location 1 to the preset reference point in the antenna feeder system, and $m_2$ is a transmission delay from a location 2 to the preset reference point in the antenna feeder system. Therefore, by using the foregoing method, detection of a plurality of PIM fault points in the antenna feeder system can always be implemented.

In addition, in this embodiment of this application, to improve system detection precision, a data sampling rate may also be increased, for example, a sampling interval T between two sampling moments is reduced; or a signal may also be continuously sampled within a predetermined time period. In other words, a larger quantity of sampling points indicates higher detection precision.

Therefore, by using the method shown in FIG. 7, a relationship between the first signal actually received by using the antenna feeder system and a pre-estimated PIM signal corresponding to the transmission delay m is converted into solving of the correlation coefficient of the transmission delay m corresponding to the detection point, so that detection of the plurality of PIM fault points and pre-estimation of corresponding interference power can be implemented quickly and accurately.

Further, after the detection of the PIM fault point is implemented, correspondingly, interference suppression may be further performed on the PIM fault point, thereby avoiding generation of a passive inter-modulation interference signal, effectively improving performance of a communication system, and improving radio resource utilization. Specifically, for example, after determining that the detection point i is the PIM fault point, the network device may eliminate, in the received uplink signal, a component that is the same as the second signal corresponding to the detection point i, thereby reducing impact of PIM interference on the communication system. The solution can be used to repair the network device before the network device is delivered from a factory, to effectively suppress (or eliminate) a passive inter-modulation interference signal that may be generated by the network device. Alternatively, the solution can be used to repair the network device periodically or in a specific period in a process of using the network device, to effectively suppress the passive inter-modulation interference signal that may be generated by the network device. Therefore, the PIM fault point is detected and suppressed, thereby avoiding generation of the passive inter-modulation interference signal, effectively improving performance of a communication system, and improving radio resource utilization.

The foregoing mainly describes the solutions provided in embodiments of this application from the perspective of the network device. It may be understood that, to implement the foregoing functions, the network device includes a corresponding hardware structure and/or software module for performing each function. A person skilled in the art should be easily aware that units, algorithms, and steps in the examples described with reference to the embodiments disclosed in this specification can be implemented in a form of hardware or a combination of hardware and computer software in this application. Whether a function is performed by hardware or hardware driven by computer software depends on a particular application and a design constraint of the technical solutions. A person skilled in the art may use different methods to implement the described functions for each particular application, but it should not be considered that the implementation goes beyond the scope of this application.

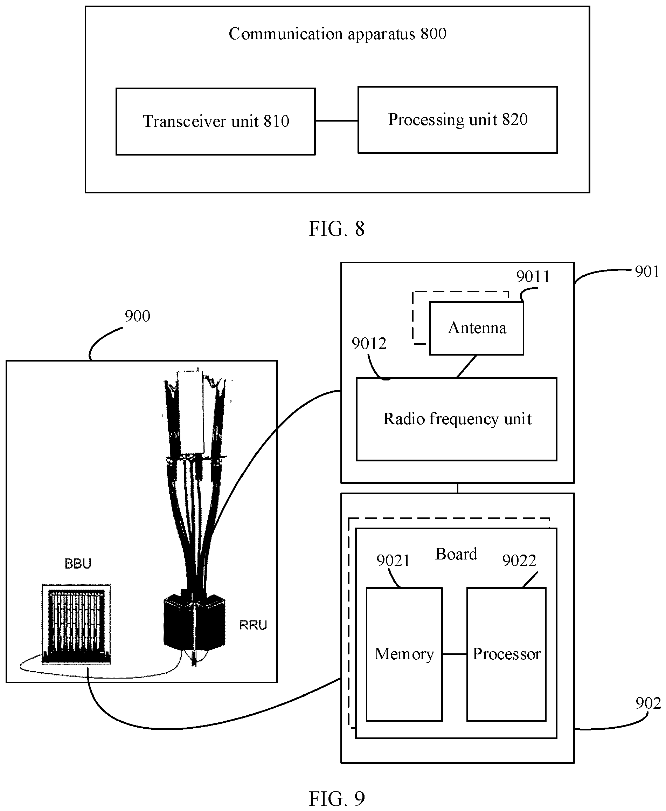

An embodiment of this application further provides a PIM fault point detection apparatus. FIG. 8 is a schematic diagram of a structure of a PIM fault point detection apparatus 800 according to an embodiment of this application. The apparatus 800 includes a transceiver unit 810 and a processing unit 820. The apparatus may be configured to implement functions involved in the network device in any one of the foregoing method embodiments. For example, the apparatus may be a network device or a chip included in the network device.

When the apparatus is used as a network device to perform the method embodiments shown in FIG. 4, FIG. 6, and FIG. 7, the transceiver unit 810 is configured to send, by using an antenna feeder system, a plurality of downlink signals of different frequencies, and receive a first signal, where the first signal is an uplink PIM signal generated by excitation by any at least two downlink signals in the plurality of downlink signals; and the processing unit 820 is configured to determine second signals corresponding to a plurality of detection points, and determine a PIM fault point from the plurality of detection points based on the first signal and the second signals corresponding to the plurality of detection points, where a second signal corresponding to any detection point is a pre-estimated signal for a PIM signal from the detection point.

In a possible design, the processing unit 820 is specifically configured to: determine PIM interference correlation coefficients corresponding to the plurality of detection points through the following step: obtaining a PIM interference correlation coefficient of at least one detection point based on the first signal and a second signal corresponding to the at least one detection point in the plurality of detection points; determine, from the at least one detection point, at least one target detection point whose PIM interference correlation coefficient meets a first condition; and determine that the target detection point is the PIM fault point.

In a possible design, the processing unit 820 is specifically configured to: determine a first sampling value of the first signal received at a preset reference point at each of a plurality of sampling moments; determine, based on the second signal corresponding to the at least one detection point, a second sampling value of the second signal corresponding to the at least one detection point received at the preset reference point at each of the plurality of sampling moments; and obtain a PIM interference correlation coefficient of a first detection point based on the first sampling value and the second sampling value corresponding to the at least one detection point.

In a possible design, duration between any two adjacent sampling moments in the plurality of sampling moments is a sampling periodicity T; and the first condition includes: an absolute value of the PIM interference correlation coefficient is greater than or equal to a specified first threshold.

In a possible design, the preset reference point is a location of a transmitter power amplifier in the network device; or the preset reference point is a location of a combiner in the antenna feeder system.

In a possible design, the processing unit 820 is further configured to: determine, after determining that the target detection point is the PIM fault point, interference power of the PIM fault point based on the PIM interference correlation coefficient corresponding to the target detection point and the second signal.

In a possible design, the processing unit 820 is specifically configured to: determine the second signals of the plurality of detection points through the following step: determining a second signal corresponding to the first detection point in the plurality of detection points based on a configuration parameter of the first detection point and a preset signal pre-estimation model, where the configuration parameter of the first detection point includes at least one or a combination of the following: a location of the first detection point; carrier frequencies of the plurality of downlink signals; transmission rates and/or transmission delays of the plurality of downlink signals; a frequency of a PIM signal generated by excitation by the plurality of downlink signals; or a transmission rate and/or a transmission delay of the PIM signal generated by excitation by the plurality of downlink signals.

In a possible design, the preset reference point is a location of a transmitter power amplifier; or the preset reference point is a location of a combiner.

It should be understood that, the processing unit 820 involved in the PIM fault point detection apparatus may be implemented by a processor and a circuit component related to a processor, and the transceiver unit 810 may be implemented by a transceiver and a circuit component related to a transceiver. Operations and/or functions of the modules/units in the PIM fault point detection apparatus are respectively intended to implement corresponding procedures of the methods shown in FIG. 4, FIG. 6, and FIG. 7. For brevity, details are not described herein again.

FIG. 9 is a schematic diagram of another structure of a PIM fault point detection apparatus according to an embodiment of this application. A PIM fault point detection apparatus 900 may be specifically a network device, for example, a base station, and is configured to implement functions involved in the network device in any one of the foregoing method embodiments.

The network device includes one or more radio units such as a remote radio unit (remote radio unit, RRU) 901 and one or more baseband units (baseband unit, BBU) (which may also be referred to as a digital unit, (digital unit, DU)) 902. The RRU 901 may be referred to as a transceiver unit, a transceiver, a transceiver circuit, a transceiver, or the like, and the RRU 901 may include at least one antenna 9011 and at least one radio frequency unit 9012. The RRU 901 is mainly configured to send and receive radio frequency signals and perform conversion between a radio frequency signal and a baseband signal. The BBU 902 is mainly configured to perform baseband processing, control the base station, and the like. The RRU 901 and the BBU 902 may be physically disposed together, or may be physically separated, that is, the base station is a distributed base station. The RRU 901 may also be replaced with an active antenna processing unit (active antenna processing unit, AAU).

The BBU 902 is a control center of the base station, may also be referred to as a processing unit, and is mainly configured to complete a baseband processing function such as channel coding, multiplexing, modulation, or spreading. For example, the BBU (the processing unit) 902 may be configured to control the base station to perform an operation procedure related to the network device in the foregoing method embodiments.

In an example, the BBU 902 may include one or more boards, and the boards may jointly support a radio access network (for example, an LTE network) having a single access standard, or may separately support radio access networks (for example, the LTE network, a 5G network, or another network) having different access standards. The BBU 902 may further include a memory 9021 and a processor 9022. The memory 9021 is configured to store necessary instructions and data. The processor 9022 is configured to control the base station to perform a necessary action, for example, is configured to control the base station to perform a sending operation in the foregoing method embodiments. The memory 9021 and the processor 9022 may serve one or more boards. In other words, a memory and a processor may be deployed on each board. Alternatively, a plurality of boards may share a same memory and a same processor. In addition, a necessary circuit may be further disposed on each board.

An embodiment of this application further provides a chip system, including: a processor. The processor is coupled to a memory, the memory is configured to store a program or instructions, and when the program or instructions are executed by the processor, the chip system is enabled to implement the method in any one of the foregoing method embodiments.

Optionally, there may be one or more processors in the chip system. The processor may be implemented by using hardware, or may be implemented by using software. When the processor is implemented by using the hardware, the processor may be a logic circuit, an integrated circuit, or the like. When the processor is implemented by using the software, the processor may be a general-purpose processor, and is implemented by reading software code stored in the memory.

Optionally, there may also be one or more memories in the chip system. The memory may be integrated with the processor, or may be disposed separately from the processor. This is not limited in this application. For example, the memory may be a non-transitory processor, for example, a read-only memory ROM. The memory and the processor may be integrated into a same chip, or may be separately disposed on different chips. A type of the memory and a manner of disposing the memory and the processor are not specifically limited in this application.

For example, the chip system may be a field programmable gate array (field programmable gate array, FPGA), an application-specific integrated circuit (application-specific integrated circuit, ASIC), a system on chip (system on chip, SoC), a central processing unit (central processing unit, CPU), a network processor (network processor, NP), a digital signal processor (digital signal processor, DSP), a micro controller unit (micro controller unit, MCU), a programmable logic device (programmable logic device, PLD), or another integrated chip.

It should be understood that, steps in the foregoing method embodiments may be implemented by using a logic circuit or instructions in a software form in the processor. The steps of the methods disclosed with reference to embodiments of this application may be directly performed by a hardware processor, or may be performed by a combination of hardware in the processor and a software module.

An embodiment of this application further provides a computer-readable storage medium. The computer storage medium stores computer-readable instructions, and when a computer reads and executes the computer-readable instructions, the computer is enabled to perform the method in any one of the foregoing method embodiments.

An embodiment of this application further provides a computer program product. When a computer reads and executes the computer program product, the computer is enabled to perform the method in any one of the foregoing method embodiments.

An embodiment of this application further provides a communication system. The communication system includes a network device and at least one terminal device.

It should be understood that, the processor in embodiments of this application may be a CPU, or may be another general-purpose processor, a DSP, an ASIC, an FPGA or another programmable logic device, a discrete gate or a transistor logic device, a discrete hardware component, or the like. The general-purpose processor may be a microprocessor, or the processor may be any conventional processor or the like.

It may be further understood that, the memory provided in embodiments of this application may be a volatile memory or a non-volatile memory, or may include a volatile memory and a non-volatile memory. The non-volatile memory may be a read-only memory (read-only memory, ROM), a programmable read-only memory (programmable ROM, PROM), an erasable programmable read-only memory (erasable PROM, EPROM), an electrically erasable programmable read-only memory (electrically EPROM, EEPROM), or a flash memory. The volatile memory may be a random access memory (random access memory, RAM), and is used as an external cache. By way of example but not limitation, RAMs in many forms such as a static random access memory (static RAM, SRAM), a dynamic random access memory (dynamic RAM, DRAM), a synchronous dynamic random access memory (synchronous DRAM, SDRAM), a double data rate synchronous dynamic random access memory (double data rate SDRAM, DDR SDRAM), an enhanced synchronous dynamic random access memory (enhanced SDRAM, ESDRAM), a synchlink dynamic random access memory (synchlink DRAM, SLDRAM), and a direct rambus random access memory (direct rambus RAM, DR RAM) may be used.

It should be noted that, when the processor is a general-purpose processor, a DSP, an ASIC, an FPGA, or another programmable logic device, discrete gate or transistor logic device, or discrete hardware component, the memory (a storage module) is integrated into the processor.

It should be noted that, the memory described in this specification aims to include but not limited to these memories and any other suitable types of memories.

It should be understood that, various numbers in various embodiments of this application are merely for differentiation for ease of description. Sequence numbers of the foregoing processes do not mean execution sequences. The execution sequences of the processes should be determined based on functions and internal logic of the processes, and should not be construed as any limitation on the implementation processes of embodiments of this application.

A person of ordinary skill in the art may be aware that, in combination with the examples described in the embodiments disclosed in this specification, units and algorithm steps may be implemented by electronic hardware or a combination of computer software and electronic hardware. Whether these functions are performed by hardware or software depends on particular applications and design constraints of the technical solutions. A person skilled in the art may use different methods to implement the described functions for each particular application, but it should not be considered that the implementation goes beyond the scope of this application.

It may be clearly understood by a person skilled in the art that, for the purpose of convenient and brief description, for a detailed working process of the foregoing system, apparatus, and unit, reference may be made to a corresponding process in the foregoing method embodiments, and details are not described herein again.

In several embodiments provided in this application, it should be understood that the disclosed system, apparatus, and method may be implemented in another manner. For example, the described apparatus embodiment is merely an example. For example, division into the units is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electrical, mechanical, or another form.

The units described as separate parts may or may not be physically separate, and parts displayed as units may or may not be physical units, may be located in one position, or may be distributed on a plurality of network units. Some or all of the units may be selected based on actual requirements to achieve the objectives of the solutions of embodiments.

In addition, functional units in embodiments of this application may be integrated into one processing unit, each of the units may exist alone physically, or two or more units may be integrated into one unit.

When the functions are implemented in the form of a software functional unit and sold or used as an independent product, the functions may be stored in a computer-readable storage medium. Based on such an understanding, the technical solutions of this application essentially, or the part contributing to the prior art, or some of the technical solutions may be implemented in a form of a software product. The computer software product is stored in a storage medium, and includes several instructions for instructing a computer device (which may be a personal computer, a server, or a network device) to perform all or some of the steps of the methods described in embodiments of this application. The foregoing storage medium includes any medium that can store program code, such as a USB flash drive, a removable hard disk, a read-only memory, a random access memory, a magnetic disk, or an optical disc.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. A passive inter-modulation PIM fault point detection method, comprising:

    sending, by a network device by using an antenna feeder system, a plurality of downlink signals of different frequencies, and receiving a first signal, wherein the first signal is an uplink PIM signal generated by excitation by any at least two downlink signals in the plurality of downlink signals;
    determining, by the network device, second signals corresponding to a plurality of detection points, wherein a second signal corresponding to any detection point is a pre-estimated signal for a PIM signal of the detection point; and
    determining, by the network device, a PIM fault point from the plurality of detection points based on the first signal and the second signals corresponding to the plurality of detection points.

2. The method according to claim 1, wherein the determining, by the network device, a PIM fault point from the plurality of detection points based on the first signal and the second signals corresponding to the plurality of detection points comprises:
determining, by the network device, PIM interference correlation coefficients corresponding to the plurality of detection points through the following step:

    obtaining a PIM interference correlation coefficient of at least one detection point based on the first signal and a second signal corresponding to the at least one detection point in the plurality of detection points;
    determining, by the network device from the at least one detection point, at least one target detection point whose PIM interference correlation coefficient meets a first condition; and
    determining, by the network device, that the target detection point is the PIM fault point.

3. The method according to claim 2, wherein the obtaining, by the network device, a PIM interference correlation coefficient of at least one detection point based on the first signal and a second signal corresponding to the at least one detection point in the plurality of detection points comprises:

    determining, by the network device, a first sampling value of the first signal received at a preset reference point at each of a plurality of sampling moments;
    determining, by the network device based on the second signal corresponding to the at least one detection point, a second sampling value of the second signal corresponding to the at least one detection point received at the preset reference point at each of the plurality of sampling moments; and
obtaining, by the network device, the PIM interference correlation coefficient of the at least one detection point based on the first sampling value and the second sampling value corresponding to the at least one detection point.

4. The method according to claim 3, wherein duration between any two adjacent sampling moments in the plurality of sampling moments is a sampling periodicity T; and
the first condition comprises: an absolute value of the PIM interference correlation coefficient is greater than or equal to a specified first threshold.

5. The method according to claim 3 or 4, wherein

the preset reference point is a location of a transmitter power amplifier in the network device; or
the preset reference point is a location of a combiner in the antenna feeder system.

6. The method according to any one of claims 2 to 5, wherein after the determining, by the network device, that the target detection point is the PIM fault point, the method further comprises:
determining, by the network device, interference power of the PIM fault point based on the PIM interference correlation coefficient corresponding to the target detection point and the second signal.

7. The method according to any one of claims 1 to 6, wherein the determining, by the network device, second signals corresponding to a plurality of detection points comprises:

determining, by the network device, the second signals of the plurality of detection points through the following step: determining a second signal corresponding to a first detection point in the plurality of detection points based on a configuration parameter of the first detection point and a preset signal pre-estimation model, wherein the configuration parameter of the first detection point comprises at least one or a combination of the following:

a location of the first detection point;
carrier frequencies of the plurality of downlink signals;
transmission rates and/or transmission delays of the plurality of downlink signals;
a frequency of a PIM signal generated by excitation by any at least two downlink signals in the plurality of downlink signals; or
a transmission rate and/or a transmission delay of the PIM signal generated by excitation by any at least two downlink signals in the plurality of downlink signals.

8. The method according to any one of claims 1 to 7, wherein the plurality of detection points meet any one of the following:

the plurality of detection points are located in the antenna feeder system;
the plurality of detection points are located near the antenna feeder system; or
at least one of the plurality of detection points is located in the antenna feeder system, and at least one of the plurality of detection points is located near the antenna feeder system.

9. A passive inter-modulation PIM fault point detection apparatus, comprising:

a transceiver unit, configured to send, by using an antenna feeder system, a plurality of downlink signals of different frequencies, and receive a first signal, wherein the first signal is an uplink PIM signal generated by excitation by any at least two downlink signals in the plurality of downlink signals; and
a processing unit, configured to determine second signals corresponding to a plurality of detection points, and determine a PIM fault point from the plurality of detection points based on the first signal and the second signals corresponding to the plurality of detection points, wherein a second signal corresponding to any detection point is a pre-estimated signal for a PIM signal of the detection point.

10. The apparatus according to claim 9, wherein the processing unit is specifically configured to:
determine PIM interference correlation coefficients corresponding to the plurality of detection points through the following step:

obtaining a PIM interference correlation coefficient of at least one detection point based on the first signal and a second signal corresponding to the at least one detection point in the plurality of detection points;
determine, from the at least one detection point, at least one target detection point whose PIM interference correlation coefficient meets a first condition; and
determine that the target detection point is the PIM fault point.

11. The apparatus according to claim 10, wherein the processing unit is specifically configured to:

determine a first sampling value of the first signal received at a preset reference point at each of a plurality of sampling moments;
determine, based on the second signal corresponding to the at least one detection point, a second sampling value of the second signal corresponding to the at least one detection point received at the preset reference point at each of the plurality of sampling moments; and
obtain the PIM interference correlation coefficient of the at least one detection point based on the first sampling value and the second sampling value.

12. The apparatus according to claim 11, wherein duration between any two adjacent sampling moments in the plurality of sampling moments is a sampling periodicity T; and
the first condition comprises: an absolute value of the PIM interference correlation coefficient is greater than or equal to a specified first threshold.

13. The apparatus according to claim 11 or 12, wherein

the preset reference point is a location of a transmitter power amplifier in the network device; or
the preset reference point is a location of a combiner in the antenna feeder system.

14. The apparatus according to any one of claims 10 to 13, wherein the processing unit is further configured to:
determine, after determining that the target detection point is the PIM fault point, interference power of the PIM fault point based on the PIM interference correlation coefficient corresponding to the target detection point and the second signal.

15. The apparatus according to any one of claims 9 to 14, wherein the processing unit is specifically configured to:

determine the second signals of the plurality of detection points through the following step: determining a second signal corresponding to a first detection point in the plurality of detection points based on a configuration parameter of the first detection point and a preset signal pre-estimation model, wherein
the configuration parameter of the first detection point comprises at least one or a combination of the following:

a location of the first detection point;
carrier frequencies of the plurality of downlink signals;
transmission rates and/or transmission delays of the plurality of downlink signals;
a frequency of a PIM signal generated by excitation by the plurality of downlink signals; or
a transmission rate and/or a transmission delay of the PIM signal generated by excitation by the plurality of downlink signals.

16. The apparatus according to any one of claims 9 to 15, wherein the plurality of detection points meet any one of the following:

the plurality of detection points are located in the antenna feeder system;
the plurality of detection points are located near the antenna feeder system; or
at least one of the plurality of detection points is located in the antenna feeder system, and at least one of the plurality of detection points is located near the antenna feeder system.

17. A passive inter-modulation PIM fault point detection apparatus, wherein the apparatus comprises at least one processor, the at least one processor is coupled to at least one memory, and
the at least one processor is configured to execute a computer program or instructions stored in the at least one memory, to enable the apparatus to perform the method according to any one of claims 1 to 8.

**18.** A computer-readable storage medium, configured to store instructions, wherein when the instructions are executed, the method according to any one of claims 1 to 8 is implemented.

FIG. 1

FIG. 2A

FIG. 2B

FIG. 3A

Metal object
and the like

Antenna

8

7

Jumper 6

5

Feeder 4

3

Jumper 2

1

Combiner

Jumper

Carrier 1   Carrier 2

9

Possible inter-
modulation fault points

FIG. 3B

| A network device sends, by using an antenna feeder system, a plurality of downlink signals of different frequencies, and receives a first signal, where the first signal is an uplink PIM signal generated by excitation by any at least two downlink signals in the plurality of downlink signals | S410 |

| The network device pre-estimates PIM signals of a plurality of detection points, to obtain a second PIM signal corresponding to each of the detection points | S420 |

| The network device determines a PIM fault point from the plurality of detection points based on the first signal and the second signals corresponding to the plurality of detection points | S430 |

FIG. 4

FIG. 5

A network device sends at least two downlink signals carried on carriers of different frequencies by using an antenna feeder system, and receives a first signal by using the antenna feeder system, where the first signal is an uplink PIM signal generated by excitation by the at least two downlink signals at detection points ⟋ S610

The network device determines second signals corresponding to a plurality of detection points, where a second signal corresponding to any detection point is a pre-estimated signal for a PIM signal of the detection point ⟋ S620

The network device determines a first sampling value of the first signal received at a preset reference point at each of a plurality of sampling moments ⟋ S631

The network device determines, based on a second signal corresponding to at least one detection point, a second sampling value of the second signal corresponding to the at least one detection point received at the preset reference point at each of the plurality of sampling moments ⟋ S632

The network device obtains a PIM interference correlation coefficient of the at least one detection point based on the first sampling value and the second sampling value corresponding to the at least one detection point ⟋ S633

The network device determines, from the at least one detection point, at least one target detection point whose PIM interference correlation coefficient meets a first condition, and determines that the target detection point is a PIM fault point ⟋ S634

FIG. 6

A network device sends at least two downlink signals carried on carriers of different frequencies by using an antenna feeder system, and receives a first signal by using the antenna feeder system, where the first signal is an uplink PIM signal generated by excitation by the at least two downlink signals ⟋ S710

The network device obtains a second signal corresponding to any transmission delay m, where the transmission delay m correspondingly represents a transmission delay for which an uplink PIM signal generated by excitation at any detection point is transmitted to a preset reference point ⟋ S720

The network device determines a first sampling value of the first signal received at the preset reference point at each of N sampling moments ⟋ S731

The network device determines, based on the second signal corresponding to the transmission delay m, a second sampling value of the second signal corresponding to the transmission delay m received at the preset reference point at each of the N sampling moments ⟋ S732

The network device obtains, based on the first sampling value and the second sampling value, a correlation coefficient of the transmission delay m as a PIM interference correlation coefficient of at least one detection point ⟋ S733

The network device determines, from the at least one detection point, at least one target detection point whose PIM interference correlation coefficient meets a first condition, and determines that the target detection point is a PIM fault point ⟋ S734

FIG. 7

Communication apparatus 800

Transceiver unit 810 — Processing unit 820

FIG. 8

901

9011

Antenna

9012

Radio frequency unit

900

BBU

RRU

Board

9021    9022

Memory — Processor

902

FIG. 9

**EP 4 191 901 A1**

# INTERNATIONAL SEARCH REPORT

| | International application No. |
|---|---|
| | **PCT/CN2021/098453** |

| A. | CLASSIFICATION OF SUBJECT MATTER |
|---|---|

H04B 17/17(2015.01)i

According to International Patent Classification (IPC) or to both national classification and IPC

| B. | FIELDS SEARCHED |
|---|---|

Minimum documentation searched (classification system followed by classification symbols)

H04B，G01R，G01S

Documentation searched other than minimum documentation to the extent that such documents are included in the fields searched

Electronic data base consulted during the international search (name of data base and, where practicable, search terms used)

WPI, EPODOC, CNPAT, CNKI: 无源, 互调, 源, 位置, 定位, 参考, 检测, 点, 相关, 预估, passive, intermodulation, source, detect, locate, reference, point, correlate, predict

| C. | DOCUMENTS CONSIDERED TO BE RELEVANT |
|---|---|

| Category* | Citation of document, with indication, where appropriate, of the relevant passages | Relevant to claim No. |
|---|---|---|
| X | CN 110431768 A (RANPLAN WIRELESS NETWORK DESIGN LTD.) 08 November 2019 (2019-11-08)<br>  description paragraphs 0076-0107, claims 1-17 | 1-18 |
| A | CN 104104455 A (ZTE CORPORATION) 15 October 2014 (2014-10-15)<br>  entire document | 1-18 |
| A | CN 106054162 A (ZHEJIANG UNIVERSITY) 26 October 2016 (2016-10-26)<br>  entire document | 1-18 |
| A | US 2015145528 A1 (SOLID, INC.) 28 May 2015 (2015-05-28)<br>  entire document | 1-18 |

☐ Further documents are listed in the continuation of Box C.　　☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **18 August 2021** | **14 September 2021** |

| Name and mailing address of the ISA/CN | Authorized officer |
|---|---|
| **China National Intellectual Property Administration (ISA/ CN)**<br>**No. 6, Xitucheng Road, Jimenqiao, Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**
**Information on patent family members**

International application No.

**PCT/CN2021/098453**

| Patent document cited in search report | | | Publication date (day/month/year) | Patent family member(s) | | | Publication date (day/month/year) |
|---|---|---|---|---|---|---|---|
| CN | 110431768 | A | 08 November 2019 | GB | 201704221 | D0 | 03 May 2017 |
| | | | | US | 2020106534 | A1 | 02 April 2020 |
| | | | | WO | 2018167509 | A1 | 20 September 2018 |
| | | | | EP | 3596850 | A1 | 22 January 2020 |
| CN | 104104455 | A | 15 October 2014 | WO | 2014166229 | A1 | 16 October 2014 |
| CN | 106054162 | A | 26 October 2016 | | None | | |
| US | 2015145528 | A1 | 28 May 2015 | US | 2018128865 | A1 | 10 May 2018 |
| | | | | WO | 2015076450 | A1 | 28 May 2015 |
| | | | | KR | 20150059899 | A | 03 June 2015 |
| US | 2015145528 | A1 | 28 May 2015 | US | 2018128865 | A1 | 10 May 2018 |
| | | | | WO | 2015076450 | A1 | 28 May 2015 |
| | | | | KR | 20150059899 | A | 03 June 2015 |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202010833998